Europäisches Patentamt

European Patent Office

Office européen des brevets

(11) Publication number: **0 375 233 B1**

# EUROPEAN PATENT SPECIFICATION

(45) Date of publication of patent specification: **18.05.94**     (51) Int. Cl.5: **G02F 1/136**

(21) Application number: **89312881.9**

(22) Date of filing: **11.12.89**

(54) **Active matrix type display device.**

(30) Priority: **20.12.88 JP 321361/88**

(43) Date of publication of application:
**27.06.90 Bulletin 90/26**

(45) Publication of the grant of the patent:
**18.05.94 Bulletin 94/20**

(84) Designated Contracting States:
**DE FR GB**

(56) References cited:
**EP-A- 0 112 700**
**US-A- 4 431 271**

**JAPAN DISPLAY ,86, 1986, pp. 208-211 ; H. OGURA et al. : "Active Matrix Color LCD Fabricated by Using Redundancy and Repair System"**

(73) Proprietor: **SEIKO EPSON CORPORATION**
**4-1, Nishishinjuku 2-chome**
**Shinjuku-ku Tokyo(JP)**

(72) Inventor: **Matsueda, Yojiro**
**c/o Seiko Epson Corp.**
**3-5 Owa 3-chome**
**Suwa-shi Nagano-ken(JP)**

(74) Representative: **Miller, Joseph et al**
**J. MILLER & CO.**
**34 Bedford Row,**
**Holborn**
**London WC1R 4JH (GB)**

## Description

The present invention relates to an active matrix type display device.

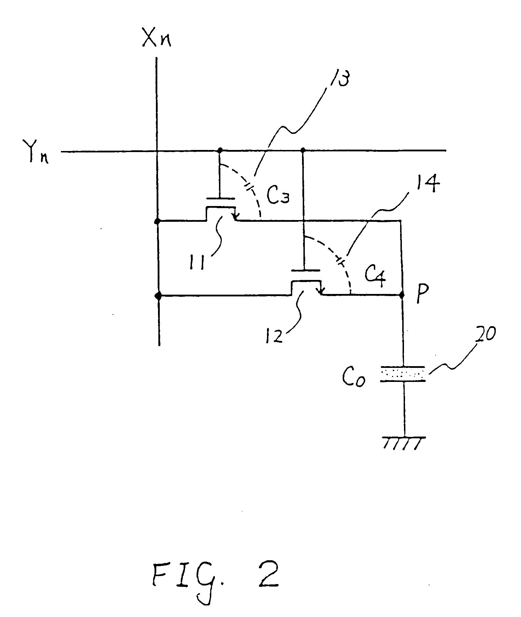

Some conventional active matrix type display devices that employ redundancy are described in Japan Display 86, pages 208 to 211, Ogura et al. Figure 2 is a circuit diagram showing one example of a liquid crystal display device employing thin film transistors (hereinafter abbreviated as "TFTs"). In the illustrated prior art, two TFTs 11 and 12 are disposed at the inter-section between a signal line Xn and a scanning line Yn, and an image signal is written in a liquid crystal cell 20.

The above described prior art suffers, however, from the following problems. Referring to Figure 2, it is assumed that the gate drain capacitances 13 and 14 of the TFTs 11 and 12 have magnitudes C3 and C4, respectively, and the liquid crystal capacitance is C0. When the scanning line Yn changes from a select state to a non-select state, the potential at a point P, that is at a pixel electrode, shifts by a voltage expressed as follows:-

$$\Delta VO = VG \times (C3 + C4) / (C3 + C4 + C0)$$

wherein VG is the change in the potential at the scanning line Yn.

On the other hand, when the TFT 12 is found to be defective and consequently the pixel is driven by the TFT 11 alone, the voltage shift is as follows:-

$$\Delta V1 = VG \times C3 / (C3 + C0)$$

Since VO does not equal V1, the voltage that is applied to the pixel in the two cases, that is when the pixel is driven by a single TFT and when it is driven by two TFTs, differs. A marked difference in the transmission factor thus occurs particularly in a half tone display. Accordingly, the pixel defect cannot be relieved even by the use of redundancy.

It is an object of the present invention to provide a display device, in which a pixel defect may be completely relieved by means of redundancy.

The present invention provides an active matrix type display device having a plurality of scanning lines, a plurality of signal lines, and pixels disposed at inter-sections of the scanning lines and the signal lines for providing a display, each pixel being driven by way of a respective plurality of thin film transistors which are connected to an associated pixel electrode, characterised in that each pixel electrode has connected thereto a respective plurality of storage capacitors arranged in parallel, and that the thin film transistors and the storage capacitors are arranged so as to permit selective disconnection of the same from the respective pixel electrodes if the operation of an associated pixel is defective.

By virtue of this arrangement according to the present invention, a defect in a pixel, caused either by a thin film transistor or by a storage capacitor connected to one of the pixel electrodes being defective, can be relieved simply by electrically disconnecting the defective portion. If a defective thin film transistor and an associated storage capacitor are simultaneously disconnected as a pair and the magnitude of the capacitance removed is optimised, it is possible still to apply to the relevant pixel the same signal as is applied to the normal pixels. In other words, the pixel defect can be completely relieved.

The present invention will be described further, by way of example, with reference to the accompanying drawings, in which like reference numerals denote like elements and in which:-

Figures 1, 3, 4, 5 and 6 are circuit diagrams showing respective embodiments of a display device according to the present invention;

Figure 2 is a circuit diagram of a conventional display device;

Figures 7 and 8 are top and sectional views respectively showing the embodiment of the display device illustrated in Figure 1;

Figures 9 and 10 are top and sectional views respectively showing another embodiment of the display device according to the present invention; and

Figures 11 and 12 are top and sectional views respectively showing a still further embodiment of the display device according to the present invention.

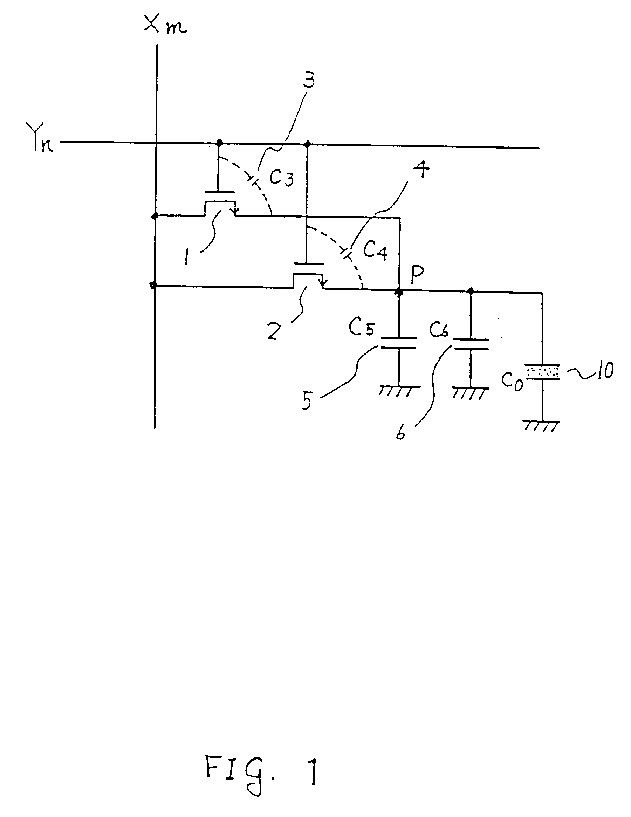

A first embodiment of the present invention will be described in detail, with reference to Figure 1, which shows a display device employing redundancy and having a liquid crystal material as an electro-optic material and two TFTs 1 and 2 for driving each pixel. These two TFTs 1 and 2 have their respective source electrodes connected to a common signal line Xm, their respective gate electrodes connected to a common scanning line Yn and their respective drain electrodes connected to a point P, that is to a common pixel electrode. Therefore, the two TFTs 1 and 2 are electrically equivalent to each other. The pixel electrode P is connected to a liquid crystal cell 10, and to storage capacitors 5 and 6, respectively.

Since an active matrix type display device generally has several tens of thousands to several millions of thin film switching elements which are disposed in a relatively large area, it is extremely difficult to produce without any defect. However, there is an exceedingly low probability that both of two elements which are adjacent to one another will become defective. Therefore, if the redundancy arrangement employed in this embodiment is adopted, it is possible to relieve a defect in a pixel by disconnecting a defective element. It is assumed that the gate-drain capacitances 3 and 4 of the TFTs 1 and 2 have magnitudes $C3$ and $C4$, respectively, the storage capacitors 5 and 6 have capacitances $C5$ and $C6$, respectively, and the capacitance of the liquid crystal cell 10 is $C0$. For simplification, it is assumed that the TFTs 1 and 2 are equivalent to one another, i.e.

$$C3 = C4 \quad (1)$$

and it is also assumed that the following relation holds for the storage capacitors 5 and 6:

$$C5 = C6 + C0 \quad (2)$$

In addition, it is assumed that both the two TFTs 1 and 2 have satisfactory writing capability.

A pixel defect is detected and relieved as follows. First, the address of a defective TFT is obtained either electrically or optically. The following are specific examples of methods for detecting a defective TFT in the substrate:

(a) the characteristics of all the TFTs are inspected by applying probes to the pixel electrodes, scanning lines and signal lines;

(b) a pin hole or foreign matter is detected by the use of a pattern recognition device; and

(c) proper signals are applied to the scanning and signal lines to detect indirectly a defective TFT. To detect a defective TFT in the panel, a method wherein the address of a defective TFT is obtained from the image pattern displayed may be employed. For example, if there is a short between the gate and source of a TFT or between the gate and drain, the scanning line select pulse appears on the signal line. Therefore, the address of the defective TFT can be obtained from the timing at which the select pulse appears. If there is a short between the source and drain of a TFT, an image signal is applied to the pixel electrode from the signal line when all the scanning lines are placed in a non-select state. Therefore, the address of the defective TFT is readily obtained from the image pattern displayed. Since the two TFTs for driving each pixel are electrically equivalent to each other, if the address of a defective TFT is obtained by a method other than pattern recognition, the defective one of the TFTs may be determined by visual inspection.

Next, the TFT that is considered to be defective is disconnected or cut off by the use of laser trimming or other similar means, and the storage capacitor 5 of the pixel concerned is also disconnected or cut off.

By disconnecting the capacitor C5, it becomes possible to apply the same voltage both to the pixel that is driven by a single TFT and to the pixels that are each driven by two TFTs and hence to correct the defect in the pixel to render it a completely normal pixel. This will be explained below in detail.

When the scanning line Yn changes from a select state to a non-select state, the potential at the pixel electrode P alters by an amount determined by the gate-drain capacitances $C3$, $C4$ of the TFTs 1 and 2, the capacitances $C5$, $C6$ of the storage capacitors 5 and 6, and the liquid crystal capacitance $C0$. The voltage shift is expressed as follows:

$$\Delta V0 = VG \times (C3 + C4) / (C3 + C4 + C5 + C6 + C0) \quad (3)$$

wherein VG is the change in the potential at the scanning line Yn.

On the other hand, when the TFT 1 is found to be defective, and consequently the TFT 1 and the storage capacitor 5 are disconnected, the voltage shift is expressed as follows:

$$\Delta V1 = VG \times C4 / (C4 + C6 + C0) \quad (4)$$

When the TFT 2 is found to be defective, and consequently the TFT 2 and the storage capacitor 5 are disconnected, the voltage shift is expressed as follows:

$$\Delta V2 = VG \times C3 / (C3 + C6 + C0) \quad (5)$$

From the equations (1), (2), (3), (4) and (5), the following relation is obtained:

$$\Delta V0 = \Delta V1 = \Delta V2 \quad (6)$$

This shows that it is possible to apply the same voltage to a pixel that is driven by a single TFT and to a pixel driven by two TFTs. In other words, it is possible to correct a defective pixel to create a completely normal pixel.

It is assumed that, in a general display device having N TFTs per pixel, the capacitance of the electro-optic material of the pixel is $C0$, the total capacitance of the storage capacitors for each pixel is Cs, the gate-drain capacitance of the i-th TFT is $c_i$ and the gate-drain capacitance of the remaining N-1 TFTs is Cn-1. In this case, the voltage shift is expressed as follows:

$$\Delta V0 = VG \times (Ci + Cn\text{-}1) / (Ci + Cn\text{-}1 + Cs + C0) \quad (7)$$

On the other hand, when the i-th TFT is found to be defective and consequently the i-th TFT and one of the storage capacitors having a capacitance Cp are disconnected, the voltage shift is expressed as follows:

$$\Delta V_i = V_G \times C_{n-1} / (C_{n-1} + C_s + C_0 - C_p) \qquad (8)$$

If, at this time, the capacitance of the storage capacitor disconnected is expressed as follows:

$$C_p = (C_0 + C_s) \times C_i / (C_i + C_{n-1}) \qquad (9)$$

then, from the equations (7), (8) and (9), the following relation is obtained:

$$\Delta V_0 = \Delta V_i \qquad (10)$$

More specifically, if it is possible to reduce the capacitance of the storage capacitors by an amount corresponding to the equation (9), then, even if the i-th TFT is disconnected and the pixel is driven by the remaining N-1 TFTs, the same voltage may be applied to the pixel as in the case where the pixel is driven by the N TFTs.

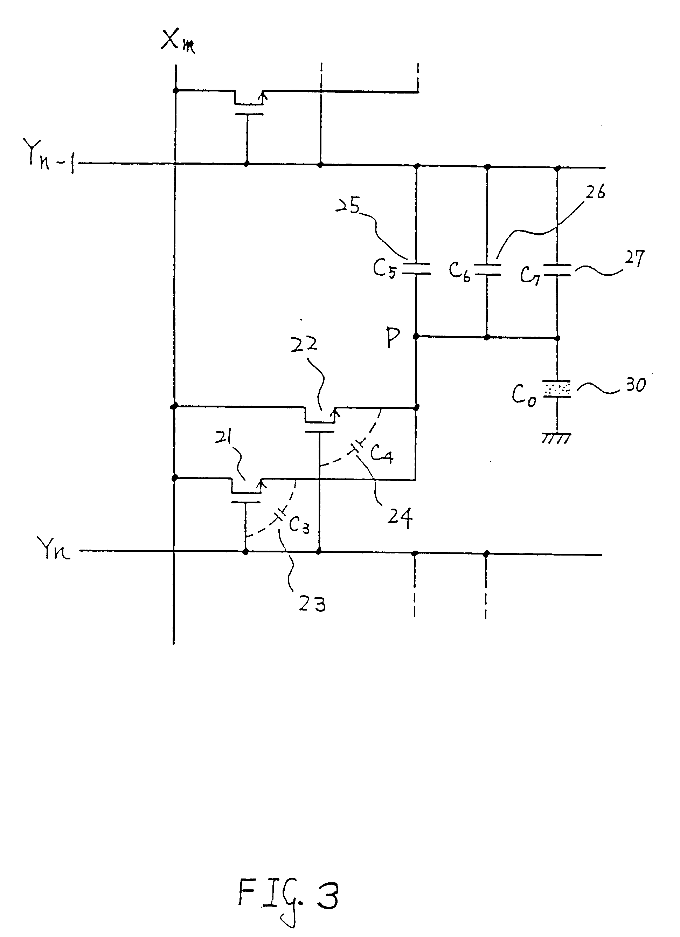

Figure 3 is a circuit diagram showing another embodiment of the present invention. In this embodiment, storage capacitors are interposed between the pixel electrode P and the scanning line $Y_{n-1}$ in the preceding stage, but the basic operation is the same as in the case of the embodiment shown in Figure 1. It is assumed that the magnitudes of the gate-drain capacitances 23 and 24 of two TFTs 21 and 22 are C3 and C4, respectively, the capacitances of three storage capacitors 25, 26 and 27 are C5, C6 and C7, respecively, and the capacitance of a liquid crystal cell 30 is C0.

If the following relations hold:

$$C3 = C4 \qquad (11)$$

$$C5 = C6 = C7 = C0 \qquad (12)$$

then, even if this pixel is found to be defective, the same voltage that is applied to the other pixels can also be applied to this pixel by disconnecting or cutting off either one of the two TFTs and any two of the three storage capacitors. For example, if the TFT 21 is found to be defective, the TFT 21 is disconnected and two storage capacitors 25 and 26, or 26 and 27, or 25 and 27, are disconnected. If the storage capacitor 25 is found to be defective, two storage capacitors 25 and 26, or 25 and 27, are disconnected and either the TFT 21 or 22 is disconnected.

Thus, the operation of the pixel can be corrected regardless of whether a TFT or a storage capacitor is defective. It is impossible, however, to correct the pixel in the following two cases, that is, when the two TFTs 21 and 22 are simultaneously defective, or when the three storage capacitors are simultaneously defective. Nevertheless, the probability that such a case will occur is extremely low. Therefore, it is possible to correct most pixel defects.

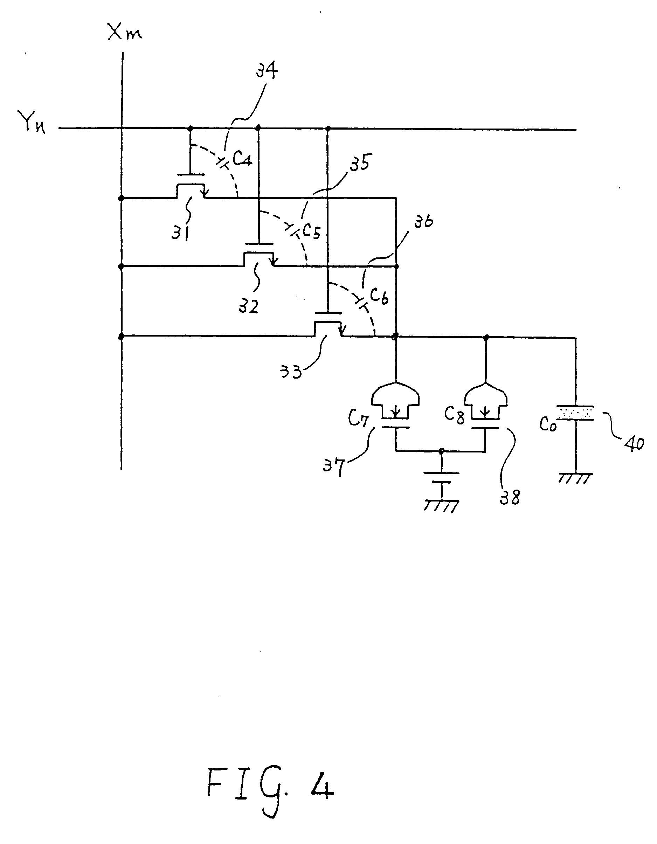

Figure 4 is a circuit diagram showing still another embodiment of the present invention. In this embodiment, MOS capacitors are employed as two storage capacitors 37 and 38, respectively, but the basic operation is the same as in the case of the embodiment shown in Figure 1. It is assumed that the magnitudes of the gate-drain capacitances 34, 35 and 36 of three TFTs 31, 32 and 33 are C4, C5 and C6, respectively, the capacitances of the two storage capacitors 37 and 38 are C7 and C8, respectively, and the capacitance of a liquid crystal cell 40 is C0.

If the following relations hold:

$$C4 = C5 = C6 \qquad (13)$$

$$C7 = C8 = C0 \qquad (14)$$

then, even if this pixel is found to be defective, the same voltage that is applied to the other pixels can still be applied thereto by disconnecting any one of the three TFTs and either of the two storage capacitors. For example, if the TFT 31 is found to be defective, the TFT 31 is disconnected and either the storage capacitor 37 or 38 is disconnected. If the storage capacitor 37 is found to be defective, the storage capacitor 37 is disconnected and any one of the three TFTs 31, 32 and 33 is disconnected. Thus, the defect in the pixel can be relieved regardless of whether a TFT or a storage capacitor is defective. It is impossible to relieve a defect in the pixel in the following two cases, that is when the three TFTs 31, 32 and 33 are simultaneously defective, or when the two storage capacitors 37 and 38 are simultaneously defective. However, the probability that such a case will occur is extremely low. Therefore, it is possible to relieve most pixel defects.

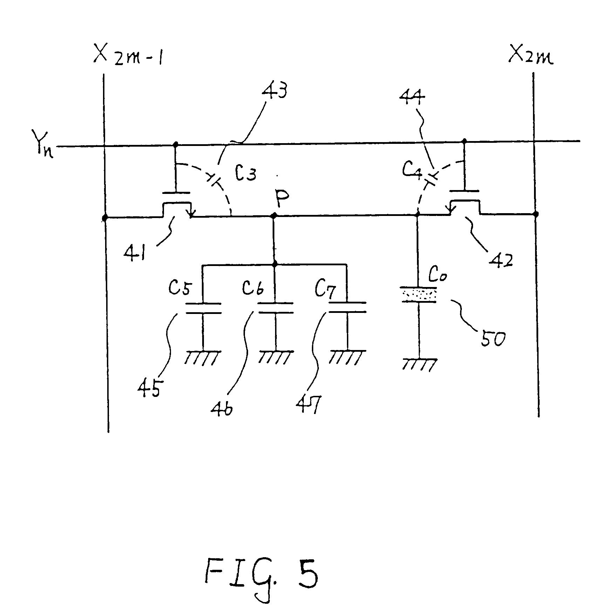

Figure 5 is a circuit diagram showing a further embodiment of the present invention. This embodiment features a redundancy arrangement wherein two TFTs 41 and 42 and two signal lines are disposed for driving each pixel. These two TFTs have their own respective gate electrodes connected to a common scanning line $Y_n$ and their respective drain electrodes connected to a common pixel electrode P. However, the source electrodes of the two TFTs are connected to signal lines $X_{2m-1}$ and $X_{2m}$, respectively. It is assumed that the capacitance of an electro-optic cell 50 is C0, the capacitances of storage capacitors 45, 46 and 47 are C5, C6 and C7, respectively, and the magnitudes of the gate-drain capacitances 43 and 44 of the two TFTs 41 and 42 are C3 and C4, respectively.

If the following relations hold:

$$C3 = C4 \quad (11)$$

$$C5 = C6 = C7 = C0 \quad (12)$$

then, even if this pixel is found to be defective, the same voltage that is applied to the other pixels can still be applied to this pixel by disconnecting either one of the two TFTs and any two of the three storage capacitors, as described above.

This embodiment, in which the signal lines are also made redundant, has the following advantages. The first advantage resides in the fact that the address of a defective TFT can be obtained readily and accurately. The address of a defective TFT may be obtained electrically by the following two methods, that is by applying a probe directly to each pixel electrode or by applying proper signals to the signal and scanning lines to obtain indirectly the address of a defective TFT. The address of a defective TFT can also be obtained extremely easily optically by making a comparison between the image pattern that is displayed on a completed panel by the application of image signals to the odd signal lines alone and the image pattern that is displayed by the application of image signals to the even signal lines alone.

The second advantage resides in the fact that it is possible to relieve a defect in a pixel resulting from a disconnection of a signal line or a short between the signal and scanning lines. If the respective terminals of the two signal lines X2m-1 and X2m are shorted to each other and the same signal is applied to them, the disconnection is automatically disregarded unless the signal line(s) is disconnected at two or more positions. If either of the signal lines X2m-1 or X2m and the scanning line Yn are shorted to each other, the signal line may be disconnected at both sides of the shorting portion, thus rendering the signal and scanning lines operative again.

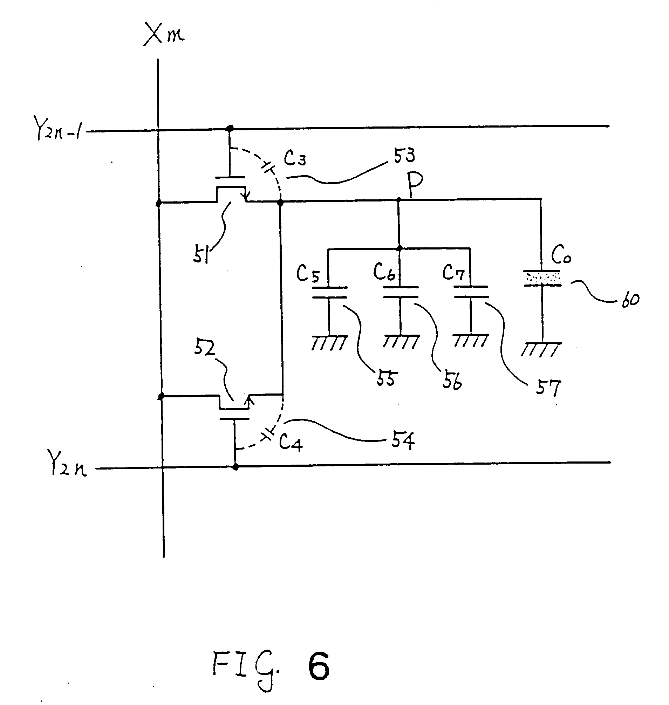

Figure 6 is a circuit diagram showing a still further embodiment of the present invention. This embodiment features a redundancy arrangement wherein two TFTs 51 and 52 and two scanning lines are provided for each pixel. These two TFTs have their respective source electrodes connected to a common signal line Xm and their respective drain electrodes connected to a common pixel electrode P. However, the gate electrodes of the two TFTs are connected to scanning lines Y2n-1 and Y2n, respectively. It is assumed that the capacitance of an electro-optic cell 60 is C0, the capacitances of storage capacitors 55, 56 and 57 are C5, C6 and C7, respectively, and the magnitudes of the gate-drain capacitances 53 and 54 of two TFTs 51 and 52 are C3 and C4, respectively.

If the following relations hold:

$$C3 = C4 \quad (11)$$

$$C5 = C6 = C7 = C0 \quad (12)$$

then, even if this pixel is found to be defective, the same voltage that is applied to the other pixels can still be applied to this pixel by disconnecting either one of the two TFTs and any two of the three storage capacitors, as described above.

This embodiment, in which the scanning lines are also made redundant, has the following advantages. The first advantage resides in the fact that the address of a defective TFT can be obtained readily and accurately. The address of a defective TFT may be obtain electrically by the following two methods, that is by applying a probe directly to each pixel electrode or by applying proper signals to the signal and scanning lines to obtain indirectly the address of a defective TFT. The address of a defective TFT can also be obtained extremely easily optically by making a comparison between the image pattern that is displayed on a completed panel by the application of scanning signals to the odd scanning lines alone and the image pattern that is displayed by the application of scanning signals to the even scanning lines alone.

The second advantage resides in the fact that it is possible to relieve a defect in a pixel resulting from a disconnection of a signal line or a short between the signal and scanning lines. If the respective terminals of the two scanning lines Y2n-1 and Y2n are shorted to each other and the same signal is applied to them, the disconnection is automatically avoided unless the scanning line(s) is disconnected at two or more positions. If the signal line Xm and either of the scanning lines Y2n-1 or Y2n are shorted to each other, the scanning line may be disconnected at both sides of the shorting portion, thus rendering the signal and scanning lines operative again.

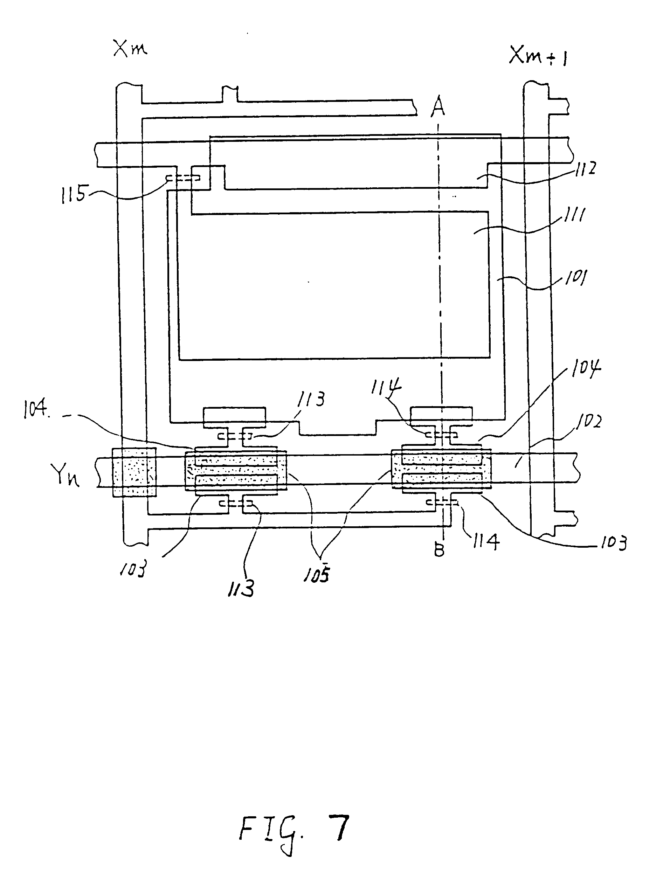

Figure 7 is a top view of one pixel of the embodiment of a display device according to the present invention shown in Figure 1. The two TFTs provided for each pixel have their sources 103 connected to the signal line Xm, and their drains 104 connected to a pixel electrode 101. Their gates 102 are constituted by the scanning line Yn itself. The reference numeral 105 denotes channel regions made of a semi-conductor film. An insulating film is formed between the semi-conductor film 105 and the gates 102. Common electrodes 111 and 112 form respective storage capacitors between the same and the pixel electrode 101. The capacitances of the storage capacitors are assumed to be C5 and C6, respectively, as mentioned above. The pixel electrode 101 faces an opposing electrode through an electro-optic material to form a capacitance there-between. The magnitude of the capacitance is assumed to be C0. Since the respective sizes of the TFTs are equal to one another, the first equation holds. It is assumed that the second equation holds for C0, C5 and C6.

If the left hand TFT is found to be defective, the portions denoted by the reference numeral 113 are cut out by means of laser trimming or another similar technique and, at the same time, the portion denoted by the reference numeral 115 is cut out to disconnect the common electrode 111. If the right hand TFT is found to be defective, the portions 114 and 115 are similarly cut out. It is preferable for the line width of the cut out portions 113 and 114 to be smaller than the width of the channel region of each TFT and for the line width of the cut out portion 115 to be smaller than the width of the pixel electrode 101.

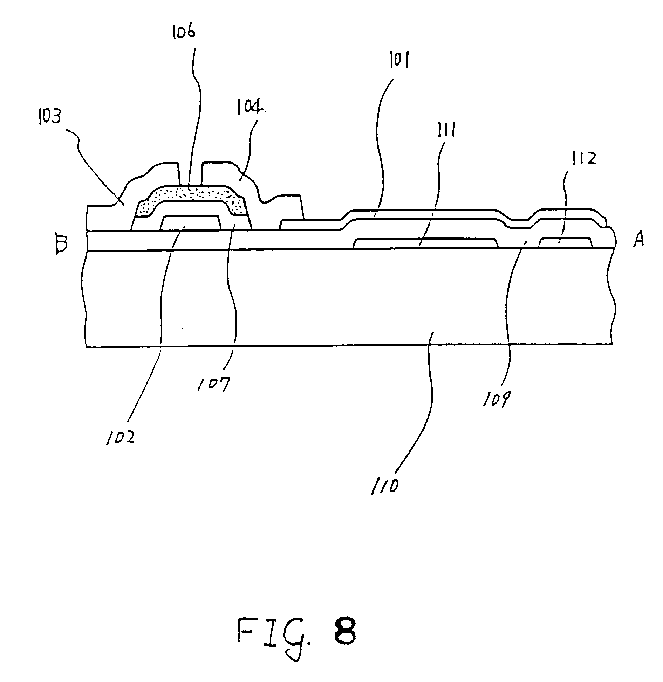

Figure 8 is a cross sectional view taken along the line A - B in Figure 7. The common electrodes 111 and 112 are provided on an insulating substrate 110 below the pixel electrode 101 with an insulating film 109 interposed there-between so that no unnecessary voltage will be applied to the electro-optic material. When inverse staggered TFTs are employed, a gate insulating film 107 and a semi-conductor film 106 are stacked over the gate 102, and the source 103 and the drain 104 are connected to the corresponding portions of the semi-conductor film 106. If transparent conductor films are employed to constitute common electrodes and pixel electrodes, a transmission type display device is formed, whereas, if a semi-conductor substrate is employed in place of the insulating substrate 110 and a metallic material is employed to constitute pixel electrodes, a reflective type display device is formed.

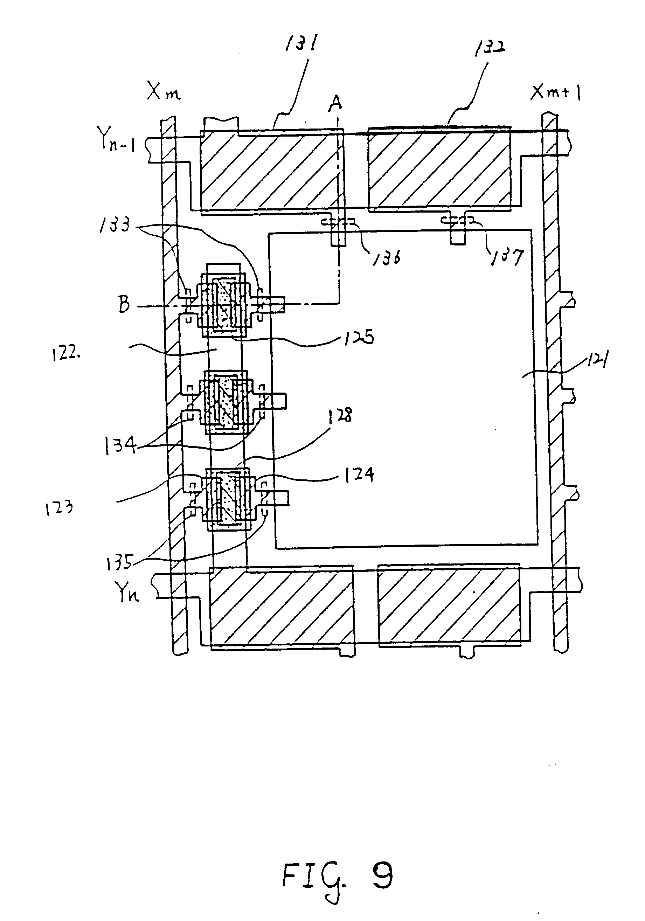

Figure 9 is a top view of one pixel of another embodiment of the display device according to the present invention. In this embodiment, three TFTs are provided for each pixel. The TFTs have their sources 123 connected to a signal line Xm, their drains 124 connected to a pixel electrode 121 and their gates 122 connected to a scanning line Yn. A semi-conductor film that is denoted by the reference numeral 125 constitutes channel regions for the TFTs. An etching stopper 128 is provided to make the film thickness of the channel regions uniform. Storage capacitor electrodes 131 and 132 face a scanning line Yn-1 in the preceding stage through an insulating film to form capacitances therebetween. The pixel electrode 121 faces an opposing electrode through an electro-optic material to constitute a capacitance. When a TFT is to be disconnected, cuts are made at portions 133, 134 or 135, whereas, when a storage capacitor is to be disconnected, cuts are made at portions 136 or 137, using laser trimming or other similar means.

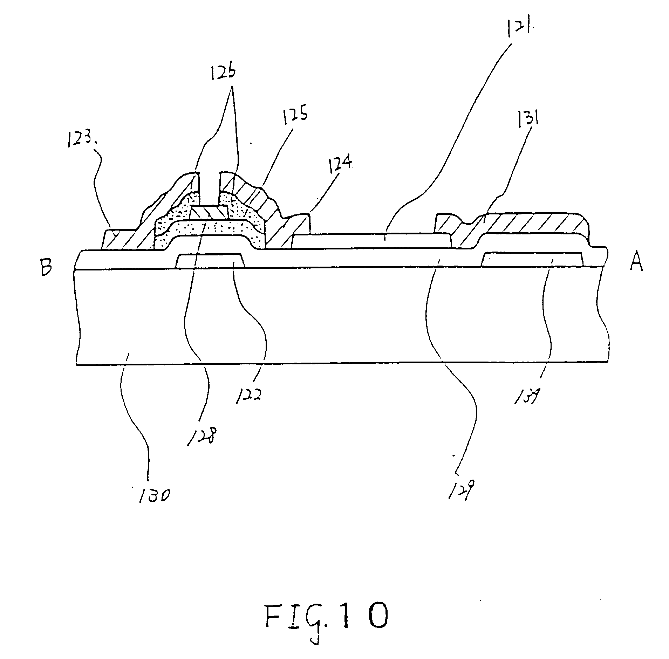

Figure 10 is a cross sectional view taken along the line A - B in Figure 9. The storage capacitor electrode 131 is provided above a scanning line 139 in the preceding stage, with an insulating film 129 interposed there-between so that no unnecessary voltage will be applied to the electro-optic material and the display quality and the reliability of the device are enhanced. When inverse staggered TFTs are employed, the insulating film 129 and the semi-conductor film 125 are stacked over the gate 122. The source 123 and the drain 124 are connected to the semi-conductor film 125 through a semi-conductor film 126 having a large amount of impurity implanted therein. The etching stopper 128 is disposed over the channel region provided by the semi-conductor film 125. The pixel electrode 121, which is formed of a transparent conductive film, is connected to both the drain 124 and the storage capacitor electrode 131. In order to increase the product yield, the insulating film 129 may comprise a multi-layer film so as to reduce pin holes.

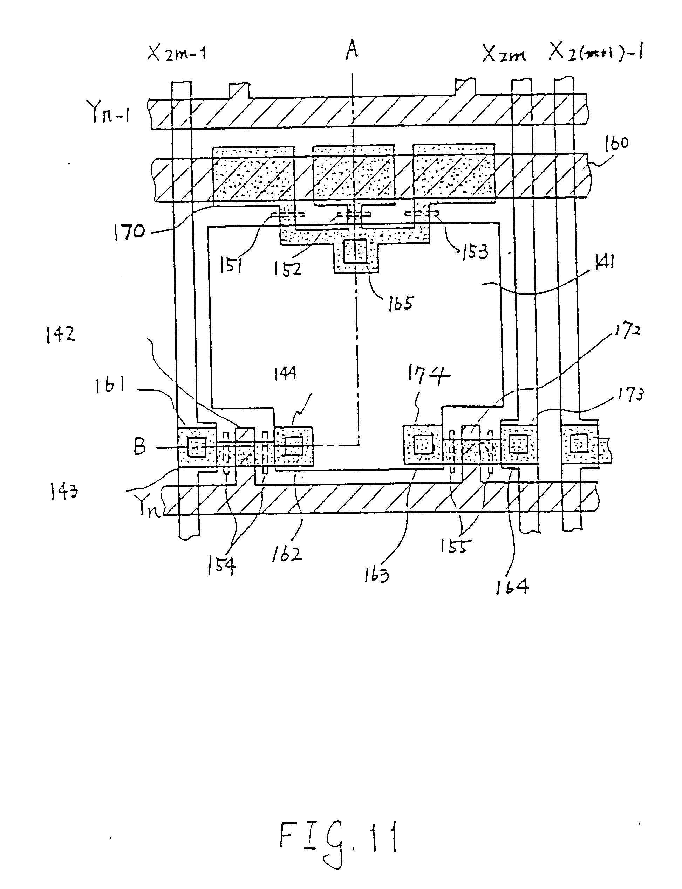

Figure 11 is a top view of one pixel of still another embodiment of the display device according to the present invention. This embodiment features a redundancy arrangement wherein two TFTs and two signal lines are provided for each pixel. The two TFTs have their sources 143 and 173 connected to signal lines X2m-1 and X2m, respectively, their drains 144 and 174 connected to a common pixel electrode 141 and their gates 142 and 172 connected to a common scanning line Yn. On the other hand, the storage capacitors are provided by a MOS capacitor comprising three portions having a common electrode 170 made of a semi-conductor material. In the case where the MOS capacitor electrode 170 has a low impurity concentration, and if the semi-conductor material is of n-type, a positive voltage is applied to a common electrode 160, whereas, if the semi-conductor material is of p-type, a negative voltage is applied to the common electrode 160, to form an inversion layer on the surface of the semi-conductor material whereby the electrode 170 functions as a MOS capacitor. In the case where the impurity concentration of the MOS capacitor electrode 170 is high, the potential at the common electrode 160 can be set as desired. If the MOS capacitor and the TFTs have the same conductivity type, the MOS capacitor can be formed at the same time as the TFTs. Contact holes 161 and 164 serve for connection between the sources of the TFTs and the corresponding signal lines, contact holes 162 and 163 serve for connection between the drains of the TFTs and the pixel electrode, and a contact hole 165 serves for connection between the MOS capacitor electrode and the pixel electrode. When a TFT is to be disconnected, cuts are made at portions 154 or 155, whereas, when a storage capacitor is to be disconnected, a cut is made at a portion 151, 152 or 153, using laser trimming or other similar means.

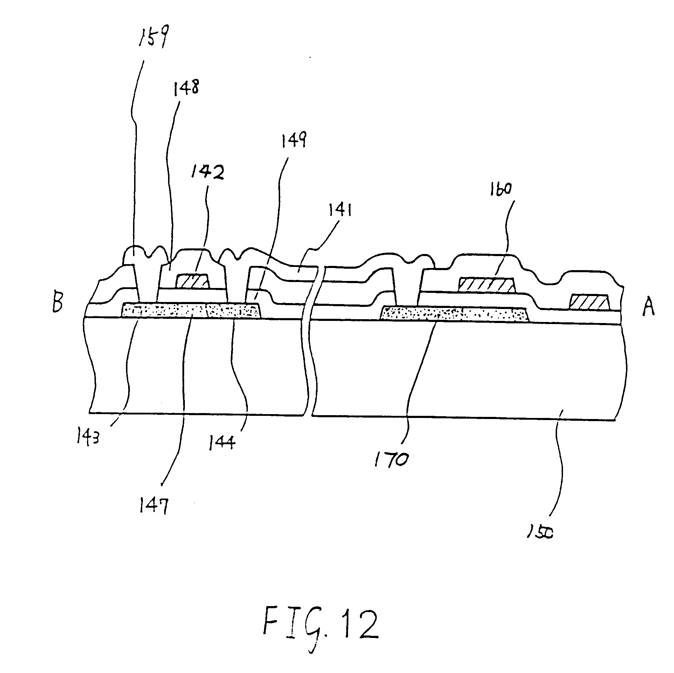

Figure 12 is a cross sectional view taken along the line A - B in Figure 11. In the case of staggered TFTs, ion implantation is carried out with the gate 142 used as a mask, so that source and drain regions 143 and 144 having a high impurity concentration and a channel region 147 having a low impurity concentration can be formed in a self aligned manner, as shown in Figure 12. It is also possible to form the TFTs in a non-self aligned manner using two semi-conductor films having different impurity concentrations. The common electrode 160 is formed of the same film as that used to form the gate 142, while the MOS capacitor electrode 170 is formed of the same semi-conductor film as that used to form the source, drain and channel regions of the TFTs. The signal line 159 and the pixel electrode 141 are connected to the source and drain regions and the MOS capacitor electrode through the respective contact holes. An inter-layer insulating film 148 isolates the scanning and signal lines from each other. If quartz is used as an insulating substrate and polycrystalline silicon as a semi-conductor material, it is possible to employ a thermal oxide film to constitute the gate insulating film 149.

The arrangements described above are applicable to any type of display device which employs a combination of TFTs and an electro-optic material. Even if the conditions of the above mentioned equations are nearly but not completely satisfied, there will be no discernible difference between a pixel relieved of a defect and the normal pixels.

As has been described above, the display device according to the present invention is capable of relieving completely a defect in a pixel regardless of whether a TFT or a storage capacitor associated with the pixel is defective. Accordingly, the product yield may be increased markedly, and it is possible to produce a defect free display device at a reduced cost. In addition, the uniformity of the picture is improved by a large margin, so that the size and density of the picture may readily be increased. Also, it is possible to provide strict gradation in a display of data including half tones, so that the range of application of the display device is enlarged.

Generally, in known active matrix type display devices, a DC voltage is applied to a defective pixel and this causes a reduction in the life of the electro-optic material. However, the present invention not only eliminates defects in pixels but also enables the same voltage to be applied both to a recovered pixel and to the normal pixels. Therefore, it is possible to realise a display device having a high reliability.

In the prior art also, where a plurality of TFTs are provided for each pixel, if a defective TFT is disconnected, a reduction in the writing capability occurs. In the present invention, however, there is no change in the load on the TFTs and, therefore, there is no change in the writing capability either. Accordingly, the design freedom is increased.

The present invention thus provides a highly advantageous arrangement based on redundancy for providing relief for defects in pixels.

**Claims**

1. An active matrix type display device having a plurality of scanning lines (Y1, ... Yn), a plurality of signal lines (X1, ... Xm), and pixels (10; 30; 40; 50; 60) disposed at inter-sections of the scanning lines and the signal lines for providing a display, each pixel being driven by way of a respective plurality of thin film transistors (1, 2; 21, 22, 31, 32, 33; 41, 42; 51, 52) which are connected to an associated pixel electrode (P), characterised in that each pixel electrode has connected thereto a respective plurality of storage capacitors (5, 6; 25, 26, 27; 37, 38; 45, 46, 47; 55, 56, 57) arranged in parallel, and that the thin film transistors and the storage capacitors are arranged so as to permit selective cutting of the connections of the thin film transistors or storage capacitors from the respective pixel electrodes if the operation of an associated pixel is defective.

2. A display device according to claim 1, characterised in that the arrangement of the thin film transistors and storage capacitors associated with each pixel is such that it allows a selected disconnection of one or a plurality of the thin film transistors associated with a given pixel and of one or a plurality of the storage capacitors associated with said given pixel which selected disconnection results in that a drive voltage applied to said pixel is substantially the same as the drive voltage applied to the other pixels keeping connected their associated thin film transistors and storage capacitors, for providing a display.

3. A display device according to claim 2, characterised in that the thin film transistors and the storage capacitors connected to each pixel electrode are arranged to permit the selective disconnection of the i-th thin film transistor and one or a plurality of the storage capacitors having a total capacitance Cp if said i-th thin film transistor or said one or a plurality of storage capacitors having said total capacitance Cp is defective, where there are a number $\underline{n}$ of the thin film transistors connected to the pixel electrode and where

$$CP = (CO + Cs) \times Ci / (Ci + Cn\text{-}1)$$

with Ci being the gate-drain capacitance of the i-th thin film transistor, Cn-1 being the gate-drain capacitance of the remaining n-1 thin film transistors, C0 being the capacitance of electro-optic material of the pixel, and Cs being the total capacitance of the storage capacitors of the pixel.

4. A display device according to any preceding claim, characterised in that the thin film transistors (102, 103, 104, 105) and the pixel electrodes (101) are formed on a substrate (110), and in that the join between each of the thin film transistors and the associated pixel electrode has a width smaller than the channel width of the thin film transistor.

5. A display device according to any preceding claim, characterised in that one of the storage capacitors connected to each pixel electrode (101) comprises a storage capacitor electrode formed by two sections (111, 112) connected by a join having a width which is smaller than the width of the pixel electrode (101).

6. A display device according to any of claims 1 to 5, characterised in that it includes an electro-optic material sandwiched between a pair of substrates, an opposing electrode formed on one of said substrates, a plurality of scanning lines (Y1, ... Yn) and a plurality of signal lines (X1, ... Xm), which are arranged in a matrix on the other substrate, a thin film transistor (1, 2, 23, 24, 31, 32, 33, 41, 42, 51, 52) provided at each of the inter-sections between said scanning and signal lines and connected to the corresponding scanning and signal lines, a pixel electrode (P) connected to said thin film transistor, and a storage capacitor (5, 6, 25, 26, 27, 37, 38, 45, 46, 47, 55, 56, 57) connected to said pixel electrode, each pixel electrode being connected to a parallel connection of a plurality of the thin film transistors and to a parallel connection of a plurality of the storage capacitors.

7. A method of manufacturing an active matrix type display device having a plurality of scanning lines (Y1, ... Yn), a plurality of signal lines (X1, ... Xm), and pixels (10, 30, 40, 50, 60) disposed at inter-sections of the scanning lines and the signal lines for providing the display, including providing for each pixel a respective plurality of thin film driving transistors (1, 2, 23, 24, 31, 32, 33, 41, 42, 51, 52) connected to an associated pixel electrode (P), and a respective plurality of storage capacitors (5, 6, 25, 26, 27, 37, 38, 45, 46, 47, 55, 56, 57) arranged in parallel connected to each pixel electrode, inspecting for a defect in the operation of a respective pixel and disconnecting a selected one or a plurality of the thin film transistors connected to a respective pixel element and a corresponding selected one or a plurality of the storage capacitors connected to the respective pixel element in the event that the operation of the associated pixel is found to be defective.

8. A method according to claim 7 characterised in that a defect in the operation of a respective pixel is detected electrically.

9. A method according to claim 7 characterised in that a defect in the operation of a respective pixel is detected optically.

**Patentansprüche**

1. Aktive Matrixanzeigevorrichtung, mit mehreren Abtastleitungen (Y1, ... Yn), mehreren Signalleitungen (X1, ... Xm) und an Kreuzungsstellen der Abtastleitungen und der Signalleitungen befindlichen Bildelementen (10; 30; 40; 50; 60) zur Schaffung einer Anzeige, von denen jedes Bildelement mit Hilfe einer zugehörigen Mehrzahl von Dünnschichttransistoren (1, 2; 21, 22, 31, 32, 33; 41, 42; 51, 52) getrieben wird, welche an eine zugehörige Bildelementelektrode (P) angeschlossen sind, dadurch gekennzeichnet, daß an jede Bildelementelektrode eine zugehörige Mehrzahl von Speicherkondensatoren (5, 6; 25, 26, 27; 37, 38; 45, 46, 47; 55, 56, 57) in Parallelschaltung angeschlossen ist, und daß die Dünnschichttransistoren und die Speicherkondensatoren derart angeordnet sind, daß ein selektives Trennen der Verbindungen der Dünnschichttransistoren oder Speicherkondensatoren von den zugehörigen Bildelementelektroden möglich ist, wenn der Betrieb eines zugehörigen Bildelements fehlerhaft ist.

**2.** Anzeigevorrichtung nach Anspruch 1, dadurch gekennzeichnet, daß die Anordnung der Dünnschichttransistoren und der Speicherkondensatoren, die jedem Bildelement zugeordnet sind, derart ist, daß sie eine ausgewählte Trennung eines oder einer Mehrzahl der zu einem gegebenen Bildelement gehörigen Dünnschichttransistoren und eines oder einer Mehrzahl der zu dem genannten gegebenen Bildelement gehörigen Speicherkondensatoren ermöglicht, wobei das ausgewählte Abtrennen dazu führt, daß eine an das Bildelement angelegte Treiberspannung im wesentlichen die gleiche ist, wie diejenige Treiberspannung, die an die anderen Bildelemente gelegt wird, bei denen die zugehörigen Dünnschichttransistoren und Speicherkondensatoren noch angeschlossen sind, um eine Anzeige zu liefern.

**3.** Anzeigevorrichtung nach Anspruch 2, dadurch gekennzeichnet, daß die Dünnschichttransistoren und die Speicherkondensatoren, die an jede Bildelementelektrode angeschlossen sind, derart angeordnet sind, daß das selektive Trennen des i-ten Dünnschichttransistors oder eines oder mehrerer Speicherkondensatoren mit einer Gesamtkapazität Cp möglich ist, wenn der i-te Dünnschichttransistor oder der eine oder die Mehrzahl von Speicherkondensatoren mit der Gesamtkapazität Cp fehlerhaft ist, wobei an die Bildelementelektrode eine Anzahl n von Dünnschichttransistoren angeschlossen ist und

$$CP = (CO + Cs) \times Ci/(Ci + Cn - 1)$$

gilt, wobei Ci die Gate-Drain-Kapazität des i-ten Dünnschichttransistors, Cn - 1 die Gate-Drain-Kapazität der übrigen n - 1 Dünnschichttransistoren, C0 die Kapazität des elektrooptischen Materials des Bildelements und Cs die Gesamtkapazität der Speicherkondensatoren des Bildelements sind.

**4.** Anzeigevorrichtung nach jedem vorhergehenden Anspruch, dadurch gekennzeichnet, daß die Dünnschichttransistoren (102, 103, 104, 105) und die Bildelementelektroden (101) auf einem Substrat ausgebildet sind, und daß die Verbindung zwischen jedem der Dünnschichttransistoren und der zugehörigen Bildelementelektrode eine Breite besitzt, die geringer ist als die Kanalbreite der Dünnschichttransistoren.

**5.** Anzeigevorrichtung nach jedem vorhergehenden Anspruch, dadurch gekennzeichnet, daß einer der an jede Bildelementelektrode (101) angeschlossenen Speicherkondensatoren eine Speicherkondensatorelektrode aufweist, die durch zwei Abschnitte (111, 112) gebildet wird, die über eine Verbindung verbunden sind, deren Breite geringer ist als die Breite der Bildelementelektrode (101).

**6.** Anzeigevorrichtung nach jedem der Ansprüche 1 bis 5, dadurch gekennzeichnet, daß sie ein elektrooptisches Material enthält, welches zwischen einem Paar von Substraten eingeschlossen ist, eine Gegenelektrode aufweist, die auf einem der Substrate ausgebildet ist, mehrere Abtastleitungen (Y1, ... Yn) und mehrere Signalleitungen (X1, ... Xm) aufweist, die auf dem anderen Substrat in Matrixform angeordnet sind, einen Dünnschichttransistor (1, 2, 23, 24, 31, 32, 33, 41, 42, 51, 52) besitzt, der an jedem der Kreuzungsstellen zwischen Abtast- und Signalleitungen vorgesehen ist und mit den entsprechenden Abtast- und Signalleitungen in Verbindung steht, eine Bildelementelektrode (P) aufweist, die an den Dünnschichttransistor angeschlossen ist, und einen Speicherkondensator (5, 6, 25, 26, 27, 37, 38, 45, 46, 47, 55, 56, 57) besitzt, der an die Bildelementelektrode angeschlossen ist, wobei jede Bildelementelektrode an eine Parallelschaltung aus mehreren der Dünnschichttransistoren und an eine Parallelschaltung aus mehreren Speicherkondensatoren angeschlossen ist.

**7.** Verfahren zum Herstellen einer aktiven Matrixanzeigevorrichtung mit mehreren Abtastleitungen (Y1, ... Yn), mehreren Signalleitungen (X1, ... Xn) und Bildelementen (10, 30, 40, 50, 60), die an Kreuzungspunkten der Abtastleitungen und der Signalleitungen angeordnet sind, um die Anzeige zu bilden, wobei für jedes Bildelement eine zugehörige Mehrzahl von Dünnschicht-Treibertransistoren (1, 2, 23, 24, 31, 32, 33, 41, 42, 51, 52) vorgesehen ist, die an eine zugehörige Bildelementelektrode (P) angeschlossen sind, und eine zugehörige Mehrzahl von Speicherkondensatoren (5, 6, 25, 26, 27, 37, 38, 45, 46, 47, 55, 56, 57) in Parallelschaltung für jede Bildelementelektrode vorgesehen wird, ein Betriebsfehler eines jeweiligen Bildelements untersucht wird und ein ausgewählter oder eine ausgewählte Mehrzahl der Dünnschichttransistoren, die an das jeweilige Bildelement angeschlossen sind und ein entsprechend ausgewählter oder eine entsprechend ausgewählte Mehrzahl von Speicherkondensatoren, die an das jeweilige Bildelement angeschlossen sind, für den Fall abgetrennt wird, daß der Betrieb des zugehörigen Bildelements sich als fehlerhaft erweist.

8. Verfahren nach Anspruch 7, dadurch gekennzeichnet, daß ein Betriebsfehler des jeweiligen Bildelements auf elektrischem Wege festge stellt wird.

9. Verfahren nach Anspruch 7, dadurch gekennzeichnet, daß ein Betriebsfehler eines jeweiligen Bildelements optisch ermittelt wird.

**Revendications**

1. Dispositif d'affichage actif de type matriciel comprenant une pluralité de lignes de balayage (Y1, ... Yn), une pluralité de lignes de signaux (X1, ... Xm), et des pixels (10 ; 30 ; 40 ; 50 ; 60) placés aux intersections des lignes de balayage et des lignes de signaux pour constituer un afficheur, chaque pixel étant commandé au moyen d'une pluralité correspondante de transistors à films minces (1, 2 ; 21, 22, 31, 32, 33 ; 41, 42 ; 51, 52) gui sont reliés à une électrode (P) de pixel associé, caractérisé en ce que chaque électrode de pixel est reliée à une pluralité correspondante de condensateurs de stockage (5, 6 ; 25, 26, 27 ; 37, 38 ; 45, 46, 47 ; 55, 56, 57) montés en parallèle, et en ce que les transistors à films minces et les condensateurs de stockage sont agencés pour permettre de couper de manière sélective les connexions des transistors à films minces ou des condensateurs de stockage aux électrodes de pixel correspondantes, si le fonctionnement d'un pixel associé est défectueux.

2. Dispositif d'affichage selon la revendication 1, caractérisé en ce que l'agencement des transistors à films minces et des condensateurs de stockage associés à chaque pixel est prévu de manière à permettre un débranchement sélectionné de l'un ou d'une pluralité de transistors à films minces associés à un pixel donné et de l'un ou d'une pluralité des condensateurs de stockage associés audit pixel donné, laquelle déconnexion sélectionnée résulte du fait qu'une tension de commande appliquée audit pixel est sensiblement la même que la tension de commande appliquée aux autre pixels, en maintenant ainsi les pixels connectés à leurs transistors à films minces et à leurs condensateurs de stockage associés pour former un dispositif d'affichage.

3. Dispositif d'affichage selon la revendication 2, caractérisé en ce que les transistors à films minces et les condensateurs de stockage reliés à chaque électrode de pixel sont agencés pour permettre la déconnexion sélective du i-ème transistor à films minces et d'un ou d'une pluralité de condensateurs de stockage ayant une capacité totale Cp si ledit i-ème transistor à films minces ou ledit condensateur ou ladite pluralité de condensateurs de stockage ayant ladite capacité totale Cp sont défectueux, alors qu'il y a un certain nombre $\underline{n}$ de transistors à films minces reliés à l'électrode de pixel et avec :

$$CP = (CO + Cs) \times Ci / (Ci + Cn-1)$$

Ci étant la capacité gachette-drain du i-ème transistor à films minces, Cn-1 étant la capacité gachette-drain des n-1 transistors à films minces restants, C0 étant la capacité du matériau électro-optique du pixel et Cs étant la capacité totale des condensateurs de stockage du pixel.

4. Dispositif d'affichage selon l'une quelconque des revendications précédentes, caractérisé en ce que les transistors à films minces (102, 103, 104, 105) et les électrodes de pixel (101) sont formés sur un substrat (110), et en ce que l'assemblage entre chacun des transistors à films minces et l'électrode de pixel associée a une largeur inférieure à la largeur du canal du transistor à films minces.

5. Dispositif d'affichage selon l'une quelconque des revendications précédentes, caractérisé en ce que l'un des condensateurs de stockage reliés à chaque électrode de pixel (101) comporte une électrode de condensateur de stockage constituée par deux parties (111, 112) reliées par un assemblage ayant une largeur inférieure à la largeur de l'électrode de pixel (101).

6. Dispositif d'affichage selon l'une quelconque des revendications 1 à 5, caractérisé en ce qu'il comprend un matériau électro-optique intercalé entre deux substrats, une électrode opposée formée sur l'un desdits substrats, une pluralité de lignes de balayage (Y1, ... Yn) et une pluralité de lignes de signaux (X1, ... Xn), qui sont disposées sous forme d'une matrice sur l'autre substrat, un transistor à films minces (1, 2, 23, 24, 31, 32, 33, 41, 42, 51, 52) placé à chacune des intersections entre lesdites lignes de balayage et lesdites lignes de signaux et relié aux lignes correspondantes de balayage et de signaux, une électrode de pixel (P) reliée audit transistor à films minces, et un condensateur de stockage (5, 6, 25, 26, 27, 37, 38, 45, 46, 47, 55, 56, 57) relié à ladite électrode de pixel, chaque électrode de pixel étant reliée au montage en parallèle d'une pluralité de transistors à films minces et à une liaison en parallèle d'une pluralité de condensateurs de stockage.

7. Procédé de fabrication d'un dispositif d'affichage actif du type matriciel comprenant une pluralité de lignes de balayage (Y1, ..., Yn), une pluralité de lignes de signaux (X1, ..., Xm), et des pixels (10, 30, 40, 50, 60) placés aux intersections des lignes de balayage et des lignes de signaux pour créer le dispositif d'affichage, comprenant l'installation pour chaque pixel d'une pluralité correspondante de transistors de commande à films minces (1, 2, 23, 24, 31, 32, 33, 41, 42, 51, 52) reliés à une électrode (P) de pixel associé, et une pluralité correspondante de condensateurs de stockage (5, 6, 25, 26, 27, 37, 38, 45, 46, 47, 55, 56, 57) montés en parallèle, reliés à chaque électrode de pixel, l'inspection recherchant un défaut de fonctionnement d'un pixel correspondant et la déconnexion d'un au choix ou d'une pluralité de transistors à films minces reliés à un élément de pixel et l'un correspondant et sélectionné ou une pluralité de condensateurs de stockage correspondants reliés à l'élément de pixel respectif au cas où le fonctionnement du pixel associé est jugé défectueux.

8. Procédé selon la revendication 7, caractérisé en ce qu'un défaut de fonctionnement d'un pixel correspondant est détecté par un procédé électrique.

9. Procédé selon la revendication 7, caractérisé en ce qu'un défaut de fonctionnement d'un pixel correspondant est détecté par un procédé optique.

FIG. 1

FIG. 2

FIG. 3

FIG. 4

FIG. 5

FIG. 6

FIG. 7

FIG. 8

FIG. 9

FIG.10

FIG. 11

FIG. 12